(19) Europäisches Patentamt
European Patent Office
Office européen des brevets

(11) **EP 1 711 958 B1**

(12) **EUROPÄISCHE PATENTSCHRIFT**

(45) Veröffentlichungstag und Bekanntmachung des Hinweises auf die Patenterteilung:
**27.07.2011 Patentblatt 2011/30**

(21) Anmeldenummer: **04802977.1**

(22) Anmeldetag: **21.12.2004**

(51) Int Cl.:
*H01L 21/02* (2006.01)      *H01L 21/3105* (2006.01)
*H01L 23/522* (2006.01)

(86) Internationale Anmeldenummer:
**PCT/DE2004/002794**

(87) Internationale Veröffentlichungsnummer:
**WO 2005/062348 (07.07.2005 Gazette 2005/27)**

(54) **Verfahren zum Herstellen eines Kondensators mit lokal erhöhter dielektrischer Konstante und eines Zwischendielektrikums mit niedriger dielektrischer Konstante**

Method for forming a capacitor with a locally increased dielectric constant and an interlayer dielectric with a low dielectric constant

Procédé de fabrication d'un condensateur ayant une constante diélectrique localement augmentée et d'un diélectrique intercouches ayant une constante diélectrique faible

(84) Benannte Vertragsstaaten:
**DE FR IT**

(30) Priorität: **23.12.2003 DE 10360933**

(43) Veröffentlichungstag der Anmeldung:
**18.10.2006 Patentblatt 2006/42**

(73) Patentinhaber: **Infineon Technologies AG**
**85579 Neubiberg (DE)**

(72) Erfinder:
  • **PENKA, Sabine**
    **82008 Unterhaching (DE)**
  • **FISCHER, Armin**
    **81825 München (DE)**

(74) Vertreter: **Viering, Jentschura & Partner**
**Postfach 22 14 43**
**80504 München (DE)**

(56) Entgegenhaltungen:
| | |
|---|---|
| EP-A- 1 195 801 | WO-A- 03/015150 |
| US-A- 5 625 528 | US-A- 5 625 528 |
| US-A1- 2002 016 085 | US-A1- 2003 134 495 |
| US-A1- 2003 134 495 | US-A1- 2003 201 465 |
| US-B1- 6 459 562 | |

• **LIU P T ET AL: "The effects of plasma treatment for low dielectric constant hydrogen silsesquioxane (HSQ)" THIN SOLID FILMS, ELSEVIER-SEQUOIA S.A. LAUSANNE, CH, Bd. 332, Nr. 1-2, 2. November 1998 (1998-11-02), Seiten 345-350, XP004223487 ISSN: 0040-6090**
• **SARAVANAN S. ET AL: 'Low k thin films based on rf plasma-polymerized aniline; Low k thin films based on rf plasma-polymerized aniline' NEW JOURNAL OF PHYSICS, INSTITUTE OF PHYSICS PUBLISHING, BRISTOL, GB LNKD- DOI: 10.1088/1367-2630/6/1/064 Bd. 6, Nr. 1, 01 Juni 2004, Seiten 64 - 64, XP020080422 ISSN: 1367-2630**
• **INTERNET CITATION: 'http: //www.semiconductorglossary.com, search for 'dielectric''**
• **INTERNET CITATION: 'Low-k-Dielektrikum', [Online] Gefunden im Internet: <URL:http: //de.wikipedia.org/wiki/Low-k-Die lektrikum> [gefunden am 2010-07-01]**
• **SCHULZE K.: 'Beiträge zur Technologieentwicklung für die Erzeugung von Airgap-Strukturen' INTERNET CITATION, [Online] Google bücher Gefunden im Internet: <URL:http://books.google.de>**
• **ZSCHECH E.: 'Materials for information technology: devices, interconnects and packaging' INTERNET CITATION, [Online] Google bücher Gefunden im Internet: <URL:http: //books.google.de>**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

- SARAVANAN S ET AL: "Low k thin films based on rf plasma-polymerized aniline; Low k thin films based on rf plasma-polymerized aniline" NEW JOURNAL OF PHYSICS, INSTITUTE OF PHYSICS PUBLISHING, BRISTOL, GB LNKD- DOI: 10.1088/1367-2630/6/1/064, vol. 6, no. 1, 1 June 2004 (2004-06-01), pages 64-64, XP020080422 ISSN: 1367-2630
- "http://www.semiconductorglossary.com, search for 'dielectric'" [retrieved on 2010-07-01]
- "Low-k-Dielektrikum" Retrieved from the Internet: URL:http://de.wikipedia.org/wiki/Low-k-Die lektrikum [retrieved on 2010-07-01]
- CHING-FA YEH ET AL: "02-plasma degradation of low-K organic dielectric and its effective solution for damascene trenches" PLASMA PROCESS-INDUCED DAMAGE, 2000 5TH INTERNATIONAL SYMPOSIUM ON MAY 22-24, 2000, PISCATAWAY, NJ, USA,IEEE, 22 May 2000 (2000-05-22), pages 81-84, XP010512880 ISBN: 978-0-9651577-4-2

**Beschreibung**

Die Erfindung betrifft ein Verfahren zum Herstellen eines Halbleiterprodukts.

In der Halbleitertechnologie, insbesondere beim Ausbilden von integrierten Schaltkreisen, werden für viele Anwendungen elektrisch isolierende Schichten benötigt. Werden Isolationsschichten in einem integrierten Schaltkreis ausgebildet, in dem auch elektrisch leitfähige Bereiche, insbesondere Leiterbahnen, enthalten sind, so tritt eine Koppelkapazität aus benachbarten Leiterbahnen und der dazwischen angeordneten dielektrischen Schicht auf. Die Kapazität zweier paralleler Leiterbahnen, deren gegenüberliegende Flächen A in einem Abstand d voneinander angeordnet sind, ergibt sich bei einer relativen Dielektrizitätskonstante ε der dielektrischen Schicht zu

$$C = \varepsilon A / d \qquad (1)$$

Mit fortschreitender Miniaturisierung der Silizium-Mikroelektronik, das heißt mit abnehmendem Abstand d zwischen benachbarten Leiterbahnen, ergibt sich besonders dann eine große Koppelkapazität C, wenn die aneinandergrenzenden Flächen A der Leiterbahnen groß sind, das heißt die Leiterbahnen über einen großen Längenbereich in dem integrierten Schaltkreis hinweg parallel zueinander verlaufen.

Probleme mit Koppelkapazitäten nehmen mit fortschreitender Verkleinerung eines integrierten Schaltkreises somit zu. Die Laufzeit eines Signals in einer Leiterbahn nimmt mit zunehmender Koppelkapazität zu, weil diese Laufzeit durch das Produkt vom ohmschen Widerstand R und Kapazität C bestimmt ist (sogenannte "RC-Verzögerung"). Ferner nimmt ein Übersprechen ("Crosstalk") zwischen Signalen auf unterschiedlichen Leiterbahnen bei der Verwirklichung einer zunehmenden Anzahl zunehmend miniaturisierter Ebenen integrierter Halbleiterbauelemente immer stärker wird und führt zu beträchtlichen Verzögerungszeiten beziehungsweise Dämpfungen solcher Signale.

Wie aus Gleichung (1) ersichtlich, ist bei vorgegebenen Strukturdimensionen A, d eine Verringerung einer Koppelkapazität C möglich, wenn die relative Dielektrizitätskonstante ε des isolierenden Materials verringert wird. Daher wird versucht, für Materialien für Isolationsschichten in integrierten Schaltkreisen solche mit einer geringen relativen Dielektrizitätskonstante ε zu verwenden (sogenannte "Low-k-Materialien").

Insbesondere in höher gelegenen Prozessierungsebenen von Halbleiterprodukten, sind Leiterbahnen in Low-k-Material eingebettet, um die Koppelkapazitäten zwischen den Leiterbahnen zu verringern.

Andererseits sind auch in Bereichen aus Low-k-Schichten passive Bauelementen wie ohmsche Widerstände, Induktivitäten oder Kapazitäten wichtige Plattformbestandteile, insbesondere zur Realisierung von Mixed-Mode-Applikationen. Dies gilt auch für Anwendungen, die eine Mischung aus unterschiedlichen Schaltungstechnologien darstellen (z.B. Analog- und Digital-Schaltungstechnik-Teilschaltkreise in unterschiedlichen Bereichen eines integrierten Schaltkreis-Produkts). Mit anderen Worten werden auch in solchen Prozessierungsebenen derartige Bauelemente, insbesondere Kapazitäten, benötigt.

Im "Front End of the Line" (FEOL) werden Kapazitäten gemäß dem Stand der Technik unter Verwendung sogenannter NCaps realisiert. Im "Back End of the Line" (BEOL) werden sogenannte MIM-Caps (Metall-Isolator-Metall) verwendet. Ein MIM-Cap ist eine dielektrische Schicht, die zwischen zwei metallischen Kondensator-Elektroden eingebettet ist. Für ein MIM-Cap wird als ein spezielles Zusatzdevice ein eigenes Dielektrikum benötigt (beispielsweise Siliziumnitrid, $Si_3N_4$, oder Aluminiumoxid, $Al_2O_3$) und ferner werden zusätzliche Maskenebenen und Prozessierungsschritte benötigt. Dies ist aufwendig und führt zu einer teuren Prozessierung.

Eine andere Realisierung von BEOL-Kapazitäten stellen die sogenannten GridCaps, CageCaps oder SandwichCaps dar (im Weiteren zusammenfassend als GridCaps bezeichnet), bei denen die beiden Elektroden des Kondensators aus der ohnehin bereitgestellten Metallverdrahtung gebildet werden und bei der das Dielektrikum aus den Inter- und/oder Intra-Metallisolierungs-Schichten gebildet wird. Spezielle Materialen, Maskenebenen oder Prozessschritte sind in diesem Fall eingespart.

Getrieben durch den Bedarf zur Reduzierung der RC-Verzögerung und des Crosstalk wird es bei kommenden Technologiegenerationen gemäß der IRTS-Roadmap zu einer sukzessiven Verringerung des k-Wertes im Back End of the Line aufgrund der Verwendung von Low-k-Materialien kommen. Mit einer Verringerung des k-Werts solcher dielektrischer Schichten kann zwar das Problem mit unerwünschten Koppelkapazitäten zwischen Metallisierungsebenen reduziert werden, simultan verkleinern sich unerwünschterweise jedoch auch die Kapazitäten der GridCaps. Für zukünftige Technologiegenerationen ist es sehr fraglich, ob mit den GridCaps noch eine ausreichende große Kapazität erreichbar sein wird, um passive Bauelemente wie integrierte Kondensatoren zu bilden.

Bei Verwendung eines Materials mit reduziertem k-Wert muss die Gesamtlänge und damit die aufzuwendende Chipfläche von GridCap-Verdrahtungen erhöht werden, um denselben Kapazitätswert zu realisieren. Für viele Anwendungen ist die maximal erreichbare Kapazität nicht mehr ausreichend, sodass GridCaps in zukünftigen Technologiegenerationen für viele Anwendungen nicht mehr verwendet werden können. Dann muss auf MIM-Caps bzw. NCaps zurückgegriffen werden, welche die oben beschriebenen Nachteile aufweisen.

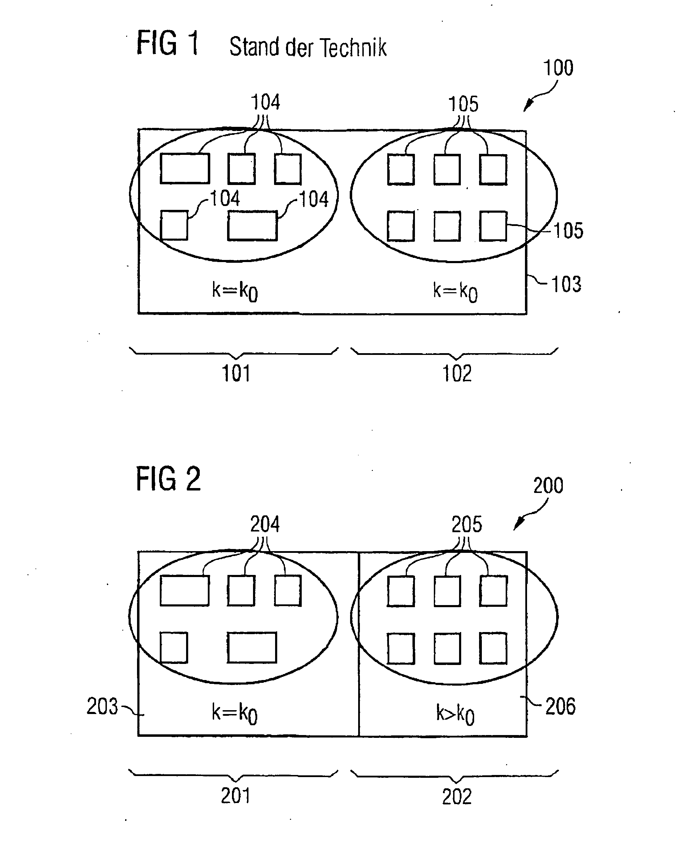

Im Weiteren wird bezugnehmend auf **Fig.1** das oben beschriebene Problem anhand eines Halbleiterprodukts gemäß dem Stand der Technik näher erläutert.

In Fig.1 ist eine Draufsicht eines Halbleiterprodukts 100 gezeigt, das einen Produkt-Abschnitt 101 und einen GridCap-Abschnitt 102 aufweist. In dem Produkt-Abschnitt 101 sind in einer dielektrischen Low-k-Schicht 103 mit einem k-Wert $k=k_0$ Produkt-Bauelemente 104 eingebettet. In der dielektrischen Low-k-Schicht 103 sind ferner in dem GridCap-Abschnitt 102 Metallisierungskomponenten 105 eingebettet, wobei auch in dem GridCap-Abschnitt 102 der Wert des k-Werts $k=k_0$ beträgt. Mit abnehmenden k-Werten nehmen zwar die Probleme in dem Produkt-Abschnitt 101 mit unerwünschten parasitären Koppelkapazitäten ab, simultan nehmen jedoch die Probleme in dem GridCap-Abschnitt 102 zu, da gemäß Gleichung (1) die erwünschten Kapazitäten zwischen Metallisierungskomponenten 105 unerwünschterweise abnehmen.

Aus [1] ist bekannt, ein unerwünschtes Erhöhen eines k-Werts in einem Low-k-Bereich eines integrierten Schaltkreises aufgrund unerwünschter Diffusion von Metallisierungsatomen in den Low-k-Bereich dadurch zu unterbinden, dass eine dünne dielektrische Liner-Schicht zwischen eine Metallisierungskomponente und ein diese umgebendes Low-k-Medium eingebracht wird.

[2] beschreibt ein poröses Substrat, wobei in die Poren zur Veränderung der elektrischen Leitfähigkeit dieses Substrats elektrisch leitfähiges Material, Low-k-Material oder alternativ High-k-Material eingebracht wird. Ferner ist in [2] beschrieben, dass mittels Einbringens von High-k-Material in die Poren in einem vorgegebenen Bereich und mittels Einbringens von elektrisch leitfähigem Material in die Poren in zwei dem mit High-k-Material gefüllten Bereich angrenzenden Bereichen eine Kapazität herzustellen.

Ferner ist aus [3] bekannt, einen Kondensator zwischen zwei sich kreuzenden elektrisch leitfähigen Leiterbahnen in einem Substrat herzustellen zum Bereitstellen von einer elektrischen Dünnschichtschaltung.

[4] beschreibt ein Verfahren zum Herstellen einer Schicht aus Low-k-Material, bei dem eine Schicht aus Material mit einer Dielektrizitätskonstante, welche geringer ist als die des zu erzeugenden Low-k-Materials und anschließendem Behandeln dieser Schicht mittels Elektronenstrahls, wodurch die Dielektrizitätskonstante in diesem Bereich, welche mit dem Elektronenstrahl behandelt wurde, erhöht wird.

[5] beschreibt Effekte von einer $NH_3$-Plasmanitridierung auf die Eigenschaften von Low-k-Hydrogen-Silsesquioxan mit Kupfer-Leiterbahnen.

Weiterhin ist in [6] beschrieben, wie ein organisches Low-k-Dielektrikum mittels Sauerstoff-Plasmabehandlung degradiert wird.

Ferner offenbart [7] ein Verfahren und eine Vorrichtung zum Abscheiden von Schichten mit niedriger Dielektrizitätskonstante, wobei die Schichten resistent gegenüber Sauerstoffdiffusion sind und einen niedrigen Sauerstoffgehalt aufweisen.

Darüberhinaus beschreibt [8] einen Dünnfilm-Kondensator und ein Verfahren zu dessen Herstellung, wobei ein dielektrischer Film auf einer Substratoberfläche abgeschieden wird.

Außerdem offenbart [9] ein Verfahren zum Herstellen eines Filmmaterials mit niedriger Dielektrizitätskonstante, wobei ein Methyl-Silesquioxan-basiertes dielektrisches Material durch eine Plasmabehandlung in poröses Siliziumdioxid umgewandelt wird.

Weiterhin sind die Effekte einer Plasmabehandlung für Hydrogen-Silesquioxan mit niedriger Dielektrizitätskonstante in [10] dargestellt.

Ferner beschreibt [11] einen Prozess zur Plasmabehandlung einer Isolationsschicht mit niedriger Permittivität, wobei ein Trockenätzplasma verwendet wird, um die Seitenwände einer Öffnung in einem Substrat, das zumindest eine Low-k-Schicht aufweist, zu verschließen.

In [12] wird ein Halbleiterherstellungsverfahren für eine isolierende kohlenstoffhaltige Low-k-Schicht beschrieben.

Der Erfindung liegt insbesondere das Problem zugrunde, eine Möglichkeit zu schaffen, mit der auch in zukünftigen Technologiegenerationen in einer Schicht aus Low-k-Material ausreichend große Kapazitäten als passive Bauelemente bereitgestellt werden können.

Das Problem wird durch ein Verfahren zum Herstellen einer Kapazität in einer Schicht aus Low-k-Material mit den Merkmalen gemäß dem unabhängigen Patentanspruch gelöst.

Gemäß dem erfindungsgemäßen Verfahren zum Herstellen einer Kapazität in einer Schicht aus Low-k-Material wird eine Schicht aus Low-k-Material gebildet, in und/oder auf der Schicht aus Low-k-Material elektrisch leitfähige Strukturen gebildet und die Schicht aus Low-k-Material zumindest in einem Kreuzungsbereich elektrisch leitfähiger Strukturen einer derartigen räumlich begrenzten Behandlung unterzogen, dass in dem Kreuzungsbereich der Wert der Dielektrizitätskonstante erhöht wird, womit eine Kapazität aus den elektrisch leitfähigen Strukturen in dem Kreuzungsbereich und dem Material mit dem erhöhten Wert der Dielektrizitätskonstante gebildet wird. Dabei bleibt die Dielektrizitätskonstante des Low-k-Materials in dem Halbleiterprodukt-Bereich unverändert. Die Schicht aus Low-k-Material wird aus einem oder einer Kombination der Materialien SiLK®, poröses SiLK®, Oxazol, poröses Oxazol, Black Diamond®,

Coral®, Nanoglass®, JSR LKD®, Hydrogen-Silsesquioxan und Methyl-Silsesquioxan gebildet.

Bei einem Verfahren zum Herstellen eines Halbleiterprodukts werden in einem Halbleiterprodukt-Bereich eines Substrats Halbleiterprodukt-Bauelement gebildet, beispielsweise Transistoren, d.h. ohmsche Widerstände, Dioden, Kapazitäten, etc. Nachfolgend wird über dem Substrat eine Schicht aus Low-k-Material gebildet und in und/oder auf der Schicht aus Low-k-Material werden elektrisch leitfähige Leiterbahnen gebildet zum elektrischen Verbinden der Halbleiterprodukt-Bauelemente, wobei die Schicht in einer Verdrahtungsebene des Halbleiterprodukts vorgesehen ist zur elektrischen Isolation der Leiterbahnen voneinander. Anschließend wird in einem Grid-Cap-Bereich des Substrats, welcher sich außerhalb des Halbleiterprodukt-Bereichs befindet, und damit außerhalb des Bereichs, in welchem die Halbleiterprodukt-Bauelement angeordnet sind, die Schicht aus Low-k-Material in mindestens einem Kreuzungsbereich der Leiterbahnen einer derartigen räumlich getrennten Behandlung unterzogen wird, dass in dem Kreuzungsbereich der Wert der Dielektrizitätskonstante erhöht wird, womit eine Leiterbahn-zu-Leiterbahn-Kapazität als Grid-Cap-Kapazität aus den in dem Kreuzungsbereich angeordneten Leiterbahnen und dem Material mit dem erhöhten Wert der Dielektrizitätskonstante gebildet wird. Die Dielektrizitätskonstante des Low-k-Materials in dem Halbleiterprodukt-Bereich verbleibt dabei unverändert, d.h. unbearbeitet.

Eine Grundidee der Erfindung beruht darauf, in einer Schicht aus Low-k-Material in räumlich begrenzten Bereichen, d.h. lokal definiert, Abschnitte mit einem erhöhten k-Wert in einer Low-k-Schicht zu schaffen. Solche räumlich begrenzten Bereiche werden vorzugsweise derart ausgewählt, dass diese Kreuzungsbereiche zwischen benachbarten elektrisch leitfähigen Strukturen (z.B. Leiterbahnen) darstellen, so dass deren Koppelkapazität als passives Bauelement, d.h. als Kapazität, mitverwendet werden kann.

Somit ist es erfindungsgemäß ermöglicht, in dem überwiegenden Teil der Schicht aus Low-k-Material unerwünschte Koppelkapazitäten gering zu halten, dadurch ein unerwünschtes Übersprechen zwischen Signalen auf unterschiedlichen Leiterbahnen (Crosstalk) zu vermeiden sowie die RC-Verzögerung gering zu halten, und simultan lokal begrenzte Bereiche aus Material mit erhöhtem k-Wert vorzusehen, so dass diese Bereiche gemeinsam mit umgebenden elektrisch leitfähigen Strukturen als integrierte Kondensatoren mit einer ausreichend hohen Kapazität verwendet werden können.

Anders ausgedrückt wird erfindungsgemäß ein Verfahren geschaffen, bei dem genau jene Bereiche des Low-k-Back-Ends speziell behandelt werden, in denen GridCaps auf eine neuartige Weise realisiert werden, um so eine gezielte Erhöhung des k-Wertes und somit der Kapazität in einem lokal begrenzten Bereich zu erreichen. Mit anderen Worten werden innerhalb des Low-k-Back-Ends gut definiert lokalisierte Bereiche mit vergrößertem k-Wert generiert, um dort hohe Line-to-Line-Kapazitäten (z.B. GridCaps) zu realisieren. Der Rest des Low-k-Back-Ends kann von dieser Behandlung unberührt bleiben, das heißt RC-Verzögerung und Crosstalk bleiben gering.

Somit wird erfindungsgemäß eine lokale Modifikation des Low-k-Materials bei Verwendung als Inter/Intrametall-Dielektrikum zur Erhöhung der Dielektrizitätskonstante und damit der Kapazität als passives Device durchgeführt.

Erfindungsgemäß wird eine k-Wert-Erhöhung explizit ausgenutzt, und nur dort lokal realisiert, wo sie in einer Low-k-Schicht erwünscht ist, nämlich im Bereich beabsichtigter GridCaps. Das restliche Low-k-Gebiet wird vorzugsweise vor einer solchen Erhöhung geschützt.

Durch eine verblüffend einfache prozesstechnische Behandlung wird die Kapazität eines herzustellenden Grid-Caps in einer Low-k-Umgebung lokal erhöht, wobei die Behandlung zum Beispiel unter Verwendung von UV-Strahlung (ultraviolette elektromagnetische Strahlung), eines RF-Plasma (z.B. Argon-Sputtern, $N_2O$) oder einer Implantation nichtleitender Atome bzw. Moleküle realisiert wird.

Zusammenfassend ist erfindungsgemäß eine gezielte Erhöhung des k-Wertes des Inter/Intrametall-Dielektrikums in lokal begrenzten Bereichen eines Low-k-Back-Ends zur Steigerung der Kapazität passiver Devices erzielt.

Ein Aspekt der Erfindung kann auch darin gesehen werden, eine Tiefenbehandlung einer Schicht aus Low-k-Material vorzunehmen, d.h. eine über das Behandeln bloß eines oberflächennahen Bereichs hinausgehende Behandlung, zum Bilden eines Bauelements. Somit können gezielt Line-to-Line-Kapazitäten mit erhöhtem k-Wert in Bereichen einer Low-k-Schicht gebildet werden.

Das Unterziehen der Schicht aus Low-k-Material einer räumlich begrenzten Behandlung kann zum Beispiel dadurch realisiert werden, dass computergestützt, unter Verwendung eines Steuerprogramms, eine Maske bzw. ein Layout definiert wird, basierend auf welchen bei Behandlung mit einem elektromagnetischen Strahl oder einem Material-Strahl in definiert vorgegebenen Bereichen eine Erhöhung des k-Wertes in der Schicht aus Low-k-Material bewirkt wird.

Bevorzugte Weiterbildungen der Erfindung ergeben sich aus den abhängigen Ansprüchen.

Die elektrisch leitfähigen Strukturen können derart verschaltet werden, dass die Kapazität als elektronisches Bauelement betrieben werden kann. Anders ausgedrückt kann die Anordnung aus Dielektrikum mit lokal erhöhtem k-Wert und den elektrisch leitfähigen Strukturen in einem Umgebungsbereich definiert als elektronisches Bauelement betrieben werden, vorzugsweise als Kapazität.

Die räumlich begrenzte Behandlung zum lokalen Erhöhen des Werts der Dielektrizitätskonstante in der Schicht aus Low-k-Material kann dadurch realisiert werden, dass auf der Schicht aus Low-k-Material eine Maskierungsschicht gebildet wird und die Maskierungsschicht strukturiert wird, womit ein Oberflächenbereich der Schicht aus Low-k-Material freigelegt wird, so dass der Bereich der Schicht aus Low-k-Material unterhalb des freigelegten Oberflächenbereichs die räumliche Begrenzung für die nachfolgenden Behandlung bildet.

Als Maske kann zum Beispiel ein Photoresist verwendet werden, der unter Verwendung eines Lithographie- und eines Ätz-Verfahrens strukturiert wird. Ein dadurch freigelegter Oberflächenbereich der Schicht aus Low-k-Material wird dadurch einer nachfolgenden Behandlung zugänglich gemacht, wohingegen der Photoresist andere Oberflächenbereiche der Schicht aus Low-k-Material vor einer nachfolgenden Behandlung schützt.

Alternativ kann die räumlich begrenzte Behandlung dadurch realisiert werden, dass Material und/oder elektromagnetische Strahlung in räumlich begrenzter Weise auf die Schicht aus Low-k-Material gerichtet wird. Wird ein Strahl aus Material (Elektronenstrahl, Molekülstrahl, etc.) oder elektromagnetischer Strahlung (UV-Strahlung, etc.) mit einem definierten Durchmesser auf die Oberfläche der Schicht aus Low-k-Material gerichtet, so wird nur der entsprechende Oberflächenbereich der Schicht aus Low-k-Material der räumlich begrenzten Behandlung unterzogen, nicht hingegen andere Bereiche der Schicht.

Wenn die Schicht aus Low-k-Material der räumlich begrenzten Behandlung unterzogen wird, kann Material der Schicht aus Low-k-Material modifiziert werden. Dies bedeutet, dass bereits vorhandenes Low-k-Material verändert, zum Beispiel chemisch verändert wird, so dass es in veränderter Form einen erhöhten k-Wert hat.

Zum Beispiel kann die Schicht aus Low-k-Material mittels Bestrahlens mit ultravioletter Strahlung modifiziert werden.

Alternativ kann die Schicht aus Low-k-Material mittels einer Plasmabehandlung modifiziert werden. Zum Beispiel weist poröses SiC0H-Material ohne eine Plasmabehandlung einen k-Wert von ungefähr 2.2 auf. Wird ein solches Material einer Helium-Plasmabehandlung unterzogen, so erhöht sich der k-Wert auf 2.4. Bei hoher Leistung wird der k-Wert von porösem SiCOH auf 3 erhöht, wenn ein $N_2O$-Plasma verwendet wird. Bei geringer Leistung und einem $N_2O$ Plasma kann der k-Wert sogar auf größer oder gleich 6 erhöht werden, siehe [1].

Die Schicht aus Low-k-Material kann auch mittels Implantierens von atomarem und/oder molekularem Material modifiziert werden. Zu diesem Zweck kann ein Molekülstrahl oder ein Atomstrahl in räumlich begrenzter Weise (fokussiert) auf die Schicht des Low-k-Materials gerichtet werden, so dass es zu einer Modifikation des Low-k-Materials derart kommt, dass das Material danach einen höheren k-Wert hat. Das Implantieren kann auch über mehrere Verdrahtungsebenen hinweg erfolgen, insbesondere wenn ein Kondensator über mehrere Metallebenen realisiert ist (sogenannte "ratio"-Variante beim Prozessieren)

Die Schicht aus Low-k-Material kann mittels Bestrahlens mit einem Elektronenstrahl ("E-beam") modifiziert werden.

Alternativ zu den beschriebenen Ausgestaltungen des Modifizierens des Low-k-Materials zum Bilden von Material mit einem erhöhten k-Wert kann, wenn die Schicht aus Low-k-Material der räumlich begrenzten Behandlung unterzogen wird, Einbring-Material in das Material der Schicht aus Low-k-Material eingebracht werden. Mit anderen Worten wird gemäß dieser Ausgestaltung nicht die vorhandene Schicht aus Low-k-Material verändert, sondern zusätzliches, externes Material in die Schicht aus Low-k-Material (physikalisch) eingebracht. Dieses zusätzliche Material führt dann zu einer Erhöhung des k-Wertes.

Bei dem Einbringen kann das Einbring-Material unter Verwendung eines Atomic-Layer-Deposition-Verfahrens (ALD-Verfahren) erfolgen. Mit dem Atomic-Layer-Deposition-Verfahren ist es möglich, eine Schicht einer sehr genau vorgebaren Dicke zu generieren, die bis auf die Genauigkeit einer Atomlage (d.h. bis auf wenige Angstrom Genauigkeit) in sehr homogener Dicke auf einer Oberfläche abgeschieden werden kann.

Anschaulich kann unter Verwendung eines ALD-Verfahrens Material wie zum Beispiel Siliziumoxid, Siliziumcarbid, Siliziumnitrid in Zwischenräume eines porösen Low-k-Materials eingebracht werden, anschaulich zum zumindest teilweisen "Auffüllen solcher Zwischenräume.

Das Einbringen von Einbring-Material kann erfolgen, indem die Schicht aus Low-k-Material als poröse Schicht gebildet wird und in die Poren der Schicht des Low-k-Materials das Einbring-Material eingebracht wird. Dies kann zum Beispiel dadurch realisiert werden, dass ein poröses Material aufweisender Wafer in einer chemischen Lösung getränkt wird, wobei in der Lösung befindliche Atome und/oder Moleküle in die Poren des Low-k-Materials eindringen.

Die Schicht aus Low-k-Material kann aus einem oder einer Kombination der Materialien SiLK®, poröses SiLK®, Oxazol, poröses Oxazol, Black Diamond®, Coral®, Nanoglass®, JSR. LKD®, Hydrogen-Silsesquioxan (HSQ) und Methyl-Silsesquioxan (MSQ) gebildet werden.

Das Low-k-Material kann auf der Basis von Polymermaterialien realisiert werden. Alternativ sind plasmaabgeschiedene Low-k- Materialien möglich, die anorganischen Charakter haben können.

Die elektrisch leitfähigen Strukturen können Leiterbahnen sein.

Die Schicht aus Low-k-Material und die elektrisch leitfähigen Strukturen können in einer Verdrahtungsebene eines Halbleiter-Chip-Produktes gebildet werden.

Insbesondere kann die Schicht aus Low-k-Material im BEOL (Back End of the Line) oder im FEOL (Front End of the Line) realisiert sein.

Ausführungsbeispiele der Erfindung sind in den Figuren dargestellt und werden im Weiteren näher erläutert.

Es zeigen:

Figur 1            eine Draufsicht eines Halbleiterprodukts gemäß dem Stand der Technik,

Figur 2            eine Draufsicht eines Halbleiterprodukts gemäß einem ersten Ausführungsbeispiel der Erfindung,

Figuren 3A, 3B          Schichtenfolgen zu unterschiedlichen Zeitpunkten während eines Verfahrens zum Herstellen einer Kapazität in einer Schicht aus Low-k-Material gemäß einem zweiten Ausführungsbeispiel der Erfindung, und Figuren 3A, 3C Schichtenfolgen zu unterschiedlichen Zeitpunkten während eines Verfahrens zum Herstellen einer Kapazität in einer Schicht aus Low-k-Material gemäß einem dritten Ausführungsbeispiel der Erfindung,

Figuren 4A bis 4D       Schichtenfolgen zu unterschiedlichen Zeitpunkten während eines Verfahrens zum Herstellen einer Kapazität in einer Schicht aus Low-k-Material gemäß einem vierten Ausführungsbeispiel der Erfindung.

Gleiche oder ähnliche Komponenten in unterschiedlichen Figuren sind mit gleichen Bezugsziffern versehen.

Die Darstellungen in den Figuren sind schematisch und nicht maßstäblich.

Im Weiteren wird bezugnehmend auf **Fig.2** eine Draufsicht eines Halbleiterprodukts 200 beschrieben, das einem erfindungsgemäßen Verfahren zum Herstellen einer Kapazität in einer Schicht aus Low-k-Material unterzogen worden ist, gemäß einem ersten Ausführungsbeispiel der Erfindung.

Das Halbleiterprodukt 200 enthält einen Produkt-Abschnitt 201 und einen GridCap-Abschnitt 202. Der Produkt-Abschnitt 201 weist eine Mehrzahl von Produkt-Bauelementen 204 auf, die in einer dielektrischen Low-k-Schicht 203 eingebettet sind. Aufgrund des geringen k-Werts $k=k_0$ in dem Produkt-Abschnitt 201 sind in dem Bereich des Produkt-Abschnitts 201 Probleme mit Kopplungskapazitäten und Cross-Talk vermieden.

Das Halbleiterprodukt 200 wird hergestellt, in dem auf einem Substrat, beispielsweise aus Silizium oder dotiertem Silizium in dem Produkt-Abschnitt 201 die für die Funktionalität des Halbleiterprodukts 200 erforderlichen Logik-Elemente, d.h. die mikroelektronischen Bauelemente hergestellt werden, beispielsweise Speicherelemente, Transistoren, Dioden, ohmsche Widerstände, Kapazitäten etc. im Rahmen des Frontend-Off-Line-Prozesses. Nach erfolgter Frontend-Off-Line-Prozessierung werden ein oder mehrere Metallisierungsebenen, auch bezeichnet als Verdrahtungsebenen über den gesamten Wafer, insbesondere über den Produkt-Abschnitt als auch über den Grid-cap-Abschnitt 202 aufgebracht, wobei als in dem Metall-Dielektrikum ein Low-k-Material verwendet wird und für die elektrisch leitfähigen Leiterbahnen üblicherweise Kupfer, wobei die Leiterbahnen im Folgenden auch als Metallisierungskomponenten 205 bezeichnet werden.

Die elektrisch leitfähigen Leiterbahnen dienen zur elektrischen Kopplung insbesondere der gebildeten mikroelektronischen Bauelemente in dem Produktabschnitt 201 mit externen Anschlüssen eines jeweils zu fertigenden Chips.

In einem GridCap-Abschnitt 202 sind eine Mehrzahl von Metallisierungskomponenten 205 aus Kupfer in einem Bereich der dielektrischen Schicht mit lokal erhöhtem k-Wert 206 $(k>k_0)$ eingebettet. Wie in Fig.2 gezeigt, weist die dielektrische Low-k-Schicht 203 einen k-Wert von $k=k_0$ auf, wohingegen der k-Wert im Bereich 206 erhöht ist, d.h. $k>k_0$. Somit sind die Koppelkapazitäten zwischen Metallisierungskomponenten 205 gemäß Gleichung (1) aufgrund des hohen k-Wertes (oder $\varepsilon$-Wertes) hoch, so dass die Kreuzungsbereiche zwischen Metallisierungskomponenten 205 und dem Material des Bereichs mit lokal erhöhtem k-Wert 206 als GridCaps realisiert sind.

Ausgehend von dem in Fig.1 gezeigten Halbleiterprodukt gemäß dem Stand der Technik kann das in Fig.2 gezeigte Halbleiterprodukt 200 gemäß der Erfindung hergestellt werden, indem nur der Produkt-Abschnitt 201 mit einem schützenden Photoresist bedeckt wird, nicht hingegen der GridCap-Abschnitt 202. Nach einer entsprechenden Behandlung mit einem Plasmastrahl wird nur das Material der dielektrischen Low-k-Schicht 203 in dem GridCap-Abschnitt 202 derart modifiziert, dass dadurch der k-Wert erhöht wird, wohingegen aufgrund des Photoresist-Materials auf dem Produkt-Abschnitt 201 dieser vor einer in diesem Abschnitt unerwünschten Erhöhung des k-Wertes geschützt ist.

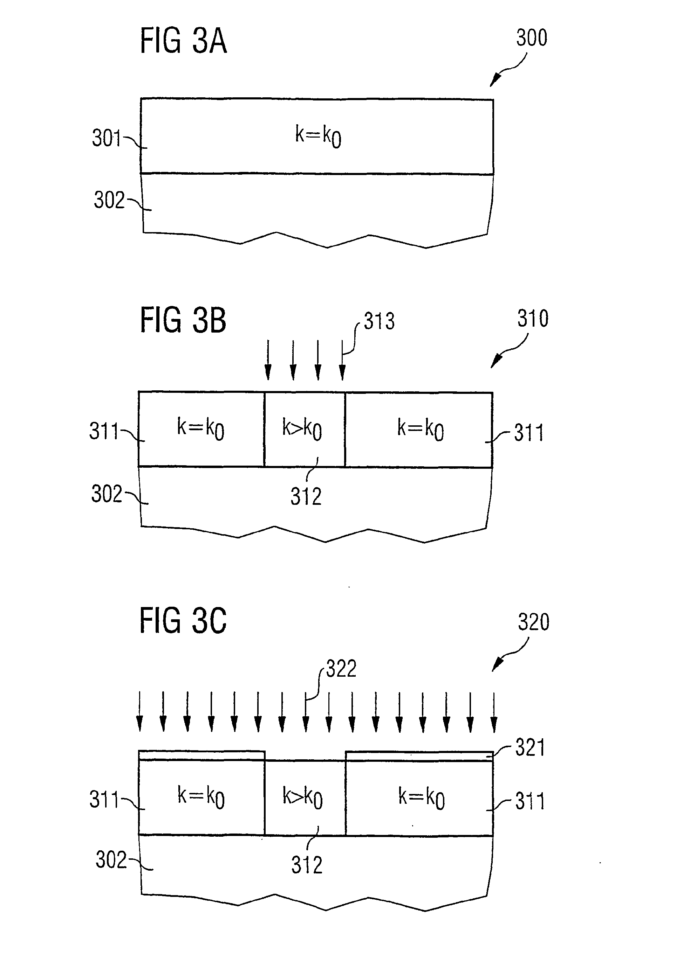

Im Weiteren wird bezugnehmend auf Fig.3A, Fig.3B ein Verfahren zum Herstellen einer Kapazität in einer Schicht aus Low-k-Material gemäß einem zweiten Ausführungsbeispiel der Erfindung beschrieben.

In **Fig.3A** ist eine Querschnittsansicht einer Schichtenfolge 300 gezeigt, bei der auf einem Substrat 302 eine Low-k-Schicht 301 mit einem geringen k-Wert $k=k_0$ gebildet ist. In dem Substrat 302 ist das eigentliche Halbleiterprodukt mittels Prozesstechniken der Halbleiter-Mikroelektronik gebildet. Die Low-k-Schicht 301 gehört zum End-of-the-Line-Bereich eines Halbleiter-Produkts.

Um die in **Fig.3B** gezeigte Schichtenfolge 310 zu erhalten, wird unter Verwendung eines lokalen Plasmas 313, d.h. eines räumlich begrenzten Plasma-Strahls, ein definierter Oberflächenbereich der Low-k-Schicht 301 modifiziert, so dass ein Bereich mit erhöhtem k-Wert 312 zwischen Low-k-Bereichen 311 gebildet wird. Die in Fig.3B gezeigte Schichtenfolge 310 enthält somit einen lokal definierten Bereich 312 mit erhöhtem k-Wert, in dem Grid-Kapazitäten aus dem Material mit erhöhtem k-Wert und in Fig.3B nicht gezeigte Metallisierungsleitungen gebildet werden. Dagegen ist in den Low-k-Bereichen 311 der Wert der RC-Verzögerung gering gehalten, da der k-Wert in diesem Bereich klein ist. Folglich sind die parasitären Koppelkapazitäten in diesen Bereichen klein. Bei dem bezugnehmend auf Fig.3A, Fig.3B beschriebenen Herstellungsverfahren ist eine separate Maske zum Definieren des räumlich begrenzten Bereichs, in dem Material mit erhöhtem k-Wert enthalten ist, vermieden.

In **Fig.3C** ist eine Schichtenfolge 320 gezeigt, die ausgehend von der in Fig.3A gezeigten Schichtenfolge 300 gemäß einem Verfahren zum Herstellen einer Kapazität in einer Schicht aus Low-k-Material gemäß einem dritten Ausführungsbeispiel der Erfindung hergestellt ist.

Um ausgehend von der in Fig.3A gezeigten Schichtenfolge 300 auf die in Fig.3C gezeigte Schichtenfolge 320 zu gelangen, wird die Low-k-Schicht 301 mit einer Schicht aus Photoresist bedeckt und der Photoresist unter Verwendung eines Lithographie- und eines Ätz-Verfahrens zu einer Maske 321 strukturiert. Nachfolgend wird ein Plasma 322 ganzflächig auf die Oberfläche der mit der Maske 321 teilweise bedeckten Schichtenfolge gerichtet, wodurch in freiliegenden Oberflächenbereichen der Schichtenfolge ein Bereich mit erhöhtem k-Wert gebildet wird. Dagegen bleiben die mit der Maske 321 bedeckten Oberflächenbereiche der Low-k-Schicht 301 unverändert, wodurch Low-k-Bereiche 311 zurückbleiben. Nach dieser Behandlung kann beispielsweise mittels Strippens die Maske 321 entfernt werden (nicht gezeigt).

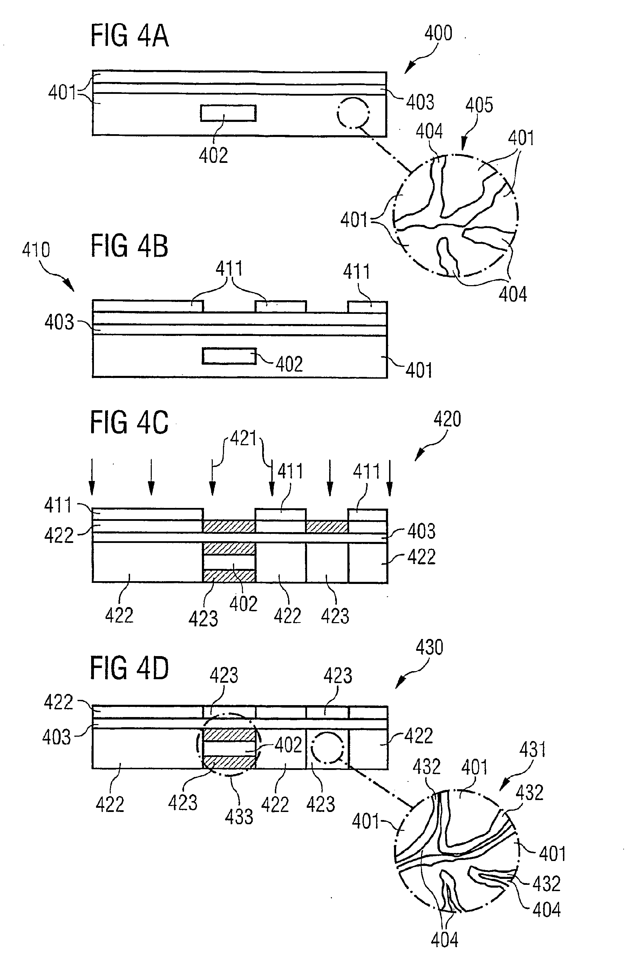

Im Weiteren wird bezugnehmend auf Fig.4A bis Fig.4D ein Verfahren zum Herstellen einer Kapazität in einer Schicht aus Low-k-Material gemäß einem vierten Ausführungsbeispiel der Erfindung beschrieben.

Um die in **Fig.4A** in einer Querschnittsansicht gezeigte Schichtenfolge 400 zu erhalten, werden erste und zweite Leiterbahnen 402, 403 aus Kupfer oder Aluminium in einer Low-k-Schicht 401 aus porösem SiLK™ gebildet. Dies kann zum Beispiel unter Verwendung eines Damascene-Verfahrens durchgeführt werden, oder mittels eines sukzessiven Bildens der Low-k-Schicht 401 beziehungsweise der Metallisierungskomponenten 402, 403 unter Verwendung von Abscheide-, Lithographie- und Ätz-Verfahren. Die erste Leiterbahn 402 verläuft senkrecht zu der Papierebene von Fig.4A.

Wie aus der Vergrößerung 405 eines Teilbereichs der Low-k-Schicht 401 zu erkennen ist, ist das Material der Low-k-Schicht 401 porös, das heißt weist Poren 404 auf.

Um die in **Fig.4B** gezeigte Schichtenfolge 410 zu erhalten, wird eine Photoresist-Schicht auf der Oberfläche der Schichtenfolge 400 abgeschieden und unter Verwendung eines Lithographie- und eines Ätz-Verfahrens strukturiert, wodurch eine Maske 411 gebildet wird.

Um die in **Fig.4C** gezeigte Schichtenfolge 420 zu erhalten, wird die mit der Maske 411 teilweise bedeckte Schichtenfolge 410 einem ALD-Verfahren unterzogen, wobei ein ALD-Materialstrahl 421 auf die Oberfläche der Schichtenfolge 410 gerichtet wird. Dieses Material, zum Beispiel Siliziumoxid oder Siliziumnitrid, dringt in die Low-k-Schicht 401 ein, füllt die darin enthaltenen Poren 404 teilweise auf und generiert somit Bereiche mit erhöhtem k-Wert 423 in der Low-k-Schicht 401. Solche Oberflächenbereiche der Low-k-Schicht 401 hingegen, die mit der Maske 411 bedeckt sind, bleiben von einer Beeinflussung durch das ALD-Verfahren frei und bilden somit Low-k-Bereiche 422.

Um die in **Fig.4D** gezeigte Schichtenfolge 430 zu erhalten, wird die Photoresist-Maske 411 von der Oberfläche der Schichtenfolge 420 entfernt.

Wie in der Vergrößerung 431 gezeigt, wird aufgrund der Behandlung der Schichtenfolge 420 mit dem ALD-Verfahren in den Poren 404 jeweils eine ALD-Schicht 432 mit gegenüber den Poren 404 des porösen SiLK erhöhtem k-Wert gebildet, so dass Bereiche 423 mit erhöhten k-Wert geschaffen werden.

Somit ist in einem Kreuzungsbereich 433 der ersten Leiterbahn 402 und der zweiten Leiterbahn 403 mit dem dazwischen befindlichen Bereich mit erhöhtem k-Wert 423, eine Kapazität geschaffen, die einen ausreichend hohen Wert der Dielektrizitätskonstante aufweist, vergleiche (1).

In diesem Dokument sind folgende Veröffentlichungen zitiert:

[1] Mourier, T, Jousseaume, V, Fusalba, F, Lecornec, C, Maury, P, Passemard, G, Haumesser, PH, Maitrejean, S, Cordeau, M, Pantel, R, Pierre, F, Fayolle, M, Feldis, H (2003) "Porous low k pore sealing process study for 65 nm and below technologies", IITC2003, San Francisco

[2] US 2003/0107465 A1

[3] DE 28 23 881 A1

[4] US 2003/0232495 A1

[5] P.-T. Liu et al., Effects of NH3-Plasma nitridation on the electrical characterisations of low-k hydrogene silsesquioxane with copper interconnects, IEEE transactions on electron devices, volume 47, No. 9, Seiten 1733 bis 1739, September 2000

[6] C.-F. Yeh et al., O2-plasma degradation of low-k organic dielectric and its effective solution for damascene trenches, 5th International Symposium on plasma process-induces damage, Seiten 81 bis 84, 23. bis 24. Mai 2000

[7] US 2002/016085 A1

[8] US 6 459 562 B1

[9] WO 03/015150 A

[10] LIU P. T. ET AL: "The effects of plasma treatment for low dielectric constant hydrogen silsesquioxane (HSQ)" THIN SOLID FILMS, ELSEVIER-SEQUOIA S.A. LAUSANNE, CH, Bd. 332, Nr. 1-2, 2. November 1998 (1998-11-02), Seiten 345-350, XP004223487 ISSN: 0040-6090

[11] EP 1 195 801 A

[12] US 2003/0201465 A1

Bezugszeichenliste

| | |
|---|---|
| 100 | Halbleiterprodukt |
| 101 | Produkt-Abschnitt |
| 102 | GridCap-Abschnitt |
| 103 | dielektrische Low-k-Schicht |
| 104 | Produkt-Bauelemente |
| 105 | Metallisierungskomponenten |
| 200 | Halbleiterprodukt |
| 201 | Produkt-Abschnitt |
| 202 | GridCap-Abschnitt |
| 203 | dielektrische Low-k-Schicht |
| 204 | Produkt-Bauelemente |
| 205 | Metallisierungskomponenten |
| 206 | Bereich mit lokal erhöhtem k-Wert |
| 300 | Schichtenfolge |
| 301 | Low-k-Schicht |
| 302 | Substrat |
| 310 | Schichtenfolge |
| 311 | Low-k-Bereiche |
| 312 | Bereich mit erhöhtem k-Wert |
| 313 | lokales Plasma |
| 320 | Schichtenfolge |
| 321 | Maske |
| 322 | Plasma |
| 400 | Schichtenfolge |
| 401 | Low-k-Schicht |
| 402 | erste Leiterbahn |
| 403 | zweite Leiterbahn |
| 404 | Poren |
| 405 | Vergrößerung |
| 410 | Schichtenfolge |
| 411 | Maske |
| 420 | Schichtenfolge |
| 421 | ALD-Materialstrahl |
| 422 | Low-k-Bereiche |
| 423 | Bereiche mit erhöhtem k-Wert |
| 430 | Schichtenfolge |
| 431 | Vergrößerung |
| 432 | ALD-Schicht |

433    Kreuzungsbereich

**Patentansprüche**

1.  Verfahren zum Herstellen eines Halbleiterprodukts (100, 200),

    • bei dem in einem Halbleiterprodukt-Bereich (101, 201) eines Substrats (302) Halbleiterprodukt-Bauelemente (104, 204) gebildet werden,
    • bei dem nachfolgend über dem Substrat (302) eine Schicht aus Low-k-Material (103, 203, 301, 401) gebildet wird,
    • bei dem in und/oder auf der Schicht aus Low-k-Material (103, 203, 301, 401) elektrisch leitfähige Leiterbahnen (402, 403) gebildet werden zum elektrischen Verbinden der Halbleiterprodukt-Bauelemente (104, 204), wobei die Schicht (103, 203, 301, 401) in einer Verdrahtungsebene des Halbleiterprodukts (100, 200) vorgesehen ist zur elektrischen Isolation der Leiterbahnen (402, 403) voneinander,
    • bei dem in einem Grid-Cap-Bereich (102, 202) des Substrats (302), welcher sich außerhalb des Halbleiterprodukt-Bereichs (101, 201) befindet, die Schicht aus Low-k-Material (103, 203, 301, 401) in mindestens einem Kreuzungsbereich (433) der Leiterbahnen (402, 403) einer derartigen räumlich begrenzten Behandlung unterzogen wird, dass in dem Kreuzungsbereich (433) der Wert der Dielektrizitätskonstante erhöht wird, womit eine Leiterbahn-zu-Leiterbahn-Kapazität als Grid-Cap-Kapazität aus den in dem Kreuzungsbereich (433) angeordneten Leiterbahnen (402, 403) und dem Material mit dem erhöhten Wert der Dielektrizitätskonstante gebildet wird,
    **dadurch gekennzeichnet,**
    **dass** die Dielektrizitätskonstante des Low-k-Materials in dem Halbleiterprodukt-Bereich (101, 201) unverändert bleibt, wobei die Schicht aus Low-k-Material (103, 203, 301, 401) aus einem oder einer Kombination der Materialien
    • SiLK®;
    • poröses SiLK®;
    • Oxazol;
    • poröses Oxazol;
    • Black Diamond®;
    • Coral®;
    • Nanoglass®;
    • JSR LKD®;
    • Hydrogen-Silsesquioxan; und
    • Methyl-Silsesquioxan
    gebildet wird.

2.  Verfahren nach Anspruch 1,
    bei dem die elektrisch leitfähigen Strukturen derart verschaltet werden, dass die Kapazität als elektronisches Bauelement betrieben werden kann.

3.  Verfahren nach Anspruch 1 oder 2,
    bei dem die räumlich begrenzte Behandlung **dadurch** realisiert wird, dass

    • auf der Schicht aus Low-k-Material (103, 203, 301, 401) eine Maskierungsschicht (321, 411) gebildet wird;
    • die Maskierungsschicht (321, 411) strukturiert wird, womit ein Oberflächenbereich der Schicht aus Low-k-Material (103, 203, 301, 401) freigelegt wird, so dass der Bereich der Schicht aus Low-k-Material (103, 203, 301, 401) unterhalb des freigelegten Oberflächenbereichs die räumliche Begrenzung für eine nachfolgende Behandlung bildet.

4.  Verfahren nach Anspruch 1 oder 2,
    bei dem die räumlich begrenzte Behandlung **dadurch** realisiert wird, dass Material und/oder elektromagnetische Strahlung in räumlich begrenzter Weise auf die Schicht aus Low-k-Material (103, 203, 301, 401) gerichtet wird.

5.  Verfahren nach einem der Ansprüche 1 bis 4,
    bei dem, während die Schicht aus Low-k-Material (103, 203, 301, 401) der räumlich begrenzten Behandlung unterzogen wird, Material der Schicht aus Low-k-Material (103, 203, 301, 401) modifiziert wird.

**6.** Verfahren nach Anspruch 5,
bei dem die Schicht aus Low-k-Material (103, 203, 301, 401) mittels Bestrahlens mit ultravioletter Strahlung modifiziert wird.

**7.** Verfahren nach Anspruch 5,
bei dem die Schicht aus Low-k-Material (103, 203, 301, 401) mittels einer Plasmabehandlung modifiziert wird.

**8.** Verfahren nach Anspruch 5,
bei dem die Schicht aus Low-k-Material (103, 203, 301, 401) mittels Implantierens von atomarem und/oder molekularem Material modifiziert wird.

**9.** Verfahren nach Anspruch 5,
bei dem die Schicht aus Low-k-Material (103, 203, 301, 401) mittels Bestrahlens mit einem Elektronenstrahl modifiziert wird.

**10.** Verfahren nach einem der Ansprüche 1 bis 4,
bei dem, während die Schicht aus Low-k-Material (103, 203, 301, 401) der räumlich begrenzten Behandlung unterzogen wird, Einbring-Material in das Material der Schicht aus Low-k-Material (103, 203, 301, 401) eingebracht wird.

**11.** Verfahren nach Anspruch 10,
bei dem das Einbringen von Einbring-Material unter Verwendung eines Atomic-Layer-Deposition-Verfahrens erfolgt.

**12.** Verfahren nach Anspruch 10 oder 11,
bei dem das Einbringen von Einbring-Material erfolgt, indem

• die Schicht aus Low-k-Material (103, 203, 301, 401) als poröse Schicht gebildet wird;
• in die Poren der Schicht aus Low-k-Material (103, 203, 301, 401) das Einbring-Material eingebracht wird.

**Claims**

**1.** A method for producing a semiconductor product (100, 200),

• in which semiconductor product components (104, 204) are formed in a semiconductor product region (101, 201) of a substrate (302),
• in which a layer made of low-k material (103, 203, 301, 401) is subsequently formed above the substrate (302),
• in which electrically conductive interconnects (402, 403) are formed in and/or on the layer made of low-k material (103, 203, 301, 401) for the purpose of electrically connecting the semiconductor product components (104, 204); the layer (103, 203, 301, 401) being provided in a wiring plane of the semiconductor product (100, 200) for the electrical insulation of the interconnects (402, 403) from one another,
• in which, in a grid cap region (102, 202) of the substrate (302), situated outside the semiconductor product region (101, 201), the layer made of low-k material (103, 203, 301, 401), in at least one crossover region (433) of the interconnects (402, 403), is subjected to a spatially delimited treatment such that the value of the dielectric constant is increased in the crossover region (433), whereby an interconnect-to-interconnect capacitance is formed as grid cap capacitance from the interconnects (402, 403) arranged in the crossover region (433) and the material having the increased value of the dielectric constant, **characterized in that**
the dielectric constant of the low-k material remaining unchanged in the semiconductor product region (103, 201), wherein the layer made of low-k material (103, 203, 301, 401) is formed from one or a combination of the materials
• SiLK®;
• porous SiLK®;
• oxazole;
• porous oxazole;
• black diamond®;
• coral®;
• nanoglass®;
• JSR LKD®;
• hydrogen silsesquioxane; and

• methyl silsesquioxane.

2.  The method as claimed in claim 1,
    in which the electrically conductive structures are connected up in such a way that the capacitance can be operated as an electronic component.

3.  The method as claimed in claim 1 or 2,
    in which the spatially delimited treatment is realized by

    • forming a masking layer (321, 411) on the layer made of low-k material (103, 203, 301, 401);
    • patterning the masking layer (321, 411), whereby a surface region of the layer made of low-k material (103, 203, 301, 401) is uncovered, so that the region of the layer made of low-k material (103, 203, 301, 401) below the uncovered surface region forms the spatial delimitation for a subsequent treatment.

4.  The method as claimed in claim 1 or 2,
    in which the spatially delimited treatment is realized by directing material and/or electromagnetic radiation onto the layer made of low-k material (103, 203, 301, 401) in a spatially delimited manner.

5.  The method as claimed in one of claims 1 to 4,
    in which, while the layer made of low-k material (103, 203, 301, 401) is being subjected to the spatially delimited treatment, material of the layer made of low-k material (103, 203, 301, 401) is modified.

6.  The method as claimed in claim 5,
    in which the layer made of low-k material (103, 203, 301, 401) is modified by means of irradiation with ultraviolet radiation.

7.  The method as claimed in claim 5,
    in which the layer made of low-k material (103, 203, 301, 401) is modified by means of a plasma treatment.

8.  The method as claimed in claim 5,
    in which the layer made of low-k material (103, 203, 301, 401) is modified by means of implantation of atomic and/or molecular material.

9.  The method as claimed in claim 5,
    in which the layer made of low-k material (103, 203, 301, 401) is modified by means of irradiation with an electron beam.

10. The method as claimed in one of claims 1 to 4,
    in which, while the layer made of low-k material (103, 203, 301, 401) is being subjected to the spatially delimited treatment, introduction material is introduced into the material of the layer made of low-k material (103, 203, 301, 401).

11. The method as claimed in claim 10,
    in which the introduction of introduction material is effected using an atomic layer deposition method.

12. The method as claimed in claim 10 or 11,
    in which the introduction of introduction material is effected by

    • forming the layer made of low-k material (103, 203, 301, 401) as a porous layer;
    • introducing the introduction material into the pores of the layer made of low-k material (103, 203, 301, 401).

**Revendications**

1.  Procédé de fabrication d'un produit (100, 200) à semiconducteur,

    • dans lequel on forme des composants (104, 204) de produit à semiconducteur dans une zone (101, 201) de produit à semiconducteur,
    • dans lequel on forme ensuite une couche en matériau (103, 203, 301, 401) à k petit sur le substrat (302),

• dans lequel on forme des pistes (402, 403) conductrices de l'électricité dans et/ou sur la couche en matériau (103, 203, 301, 401) à k petit, pour relier électriquement le produit à semiconducteur, la couche (103, 203, 301, 401) étant prévue dans un plan de câblage du produit (100, 200) à semiconducteur pour l'isolation électrique des pistes (402, 403) conductrices entre elles,

• dans lequel on soumet, dans une zone (102, 202) grid-cap du substrat (302), qui se trouve à l'extérieur de la zone (101, 201) de produit à semiconducteur, la couche en matériau (103, 203, 301, 401) à k petit dans au moins une zone (433) d'intersection des pistes (402, 403) conductrices à un traitement limité localement, de manière à augmenter la valeur de la constante diélectrique dans la zone (433) d'intersection, en formant ainsi une capacité piste conductrice à piste conductrice en tant que capacité grid-cap à partir des pistes (402, 403) conductrices disposées dans la zone (433) d'intersection et du matériau ayant une valeur augmentée de la constante diélectrique, **caractérisé**

**en ce que** la constante diélectrique du matériau à k petit reste inchangée dans la zone (101, 201) du produit à semiconducteur, la couche en matériau (103, 203, 301, 401) à k petit étant formée de l'un des matériaux ou d'une combinaison des matériaux

• SiLK (marque de fabrique) ;
• SiLK (marque de fabrique) poreux ;
• oxazol,
• oxasol poreux
• Diamond (marque de fabrique) noir ;
• Coral (marque de fabrique) ;
• Nanoglass (marque de fabrique) ;
• JSR LKD (marque de fabrique) ;
• silsesquioxane d'hydrogène ; et
• silsesquioxane de méthyle.

2. Procédé suivant la revendication 1,
dans lequel les structures conductrices de l'électricité sont câblées, de manière à ce que la capacité puisse fonctionner en tant que composant électronique.

3. Procédé suivant la revendication 1 ou 2,
dans lequel on réalise le traitement limité localement

• en formant une couche (321, 411) de masquage sur la couche en matériau (103, 203, 301, 401) à k petit ;
• en structurant la couche (321, 411) de masquage, ce qui dénude une partie de la surface de la couche en matériau (103, 203, 301, 401) à k petit, de sorte que la zone de la couche en matériau (103, 203, 301, 401) à k petit forme en dessous de la zone de la surface mise à nu la limitation locale pour un traitement venant ensuite.

4. Procédé suivant la revendication 1 ou 2,
dans lequel on réalise le traitement limité localement en dirigeant du matériau et/ou un rayonnement électromagnétique d'une façon limitée localement sur la couche en matériau (103, 203, 301, 401) à k petit.

5. Procédé suivant l'une des revendications 1 à 4,
dans lequel pendant que la couche en matériau (103, 203, 301, 401) à k petit est soumise au traitement limité localement, on modifie le matériau de la couche en matériau (103, 203, 301, 401) à k petit.

6. Procédé suivant la revendication 5,
dans lequel on modifie la couche en matériau (103, 203, 301, 401) à k petit au moyen d'une exposition à du rayonnement ultraviolet.

7. Procédé suivant la revendication 5,
dans lequel on modifie la couche en matériau (103, 203, 301, 401) à k petit au moyen d'un traitement au plasma.

8. Procédé suivant la revendication 5,
dans lequel on modifie la couche en matériau (103, 203, 301, 401) à k petit au moyen d'une implantation de matériau atomique et/ou moléculaire.

9. Procédé suivant la revendication 5,
dans lequel on modifie la couche en matériau (103, 203, 301, 401) à k petit au moyen d'une exposition à un jet d'électron.

10. Procédé suivant l'une des revendications 1 à 4,
dans lequel, pendant que la couche en matériau (103, 203, 301, 401) à k petit est soumise au traitement limité localement, on introduit du matériau d'introduction dans le matériau de la couche en matériau (103, 203, 301, 401) à k petit.

11. Procédé suivant la revendication 10,
dans lequel l'introduction de matériau d'introduction s'effectue en utilisant un procédé de dépôt en couche atomique.

12. Procédé suivant la revendication 10 ou 11,
dans lequel l'introduction de matériau d'introduction s'effectue

• en formant la couche en matériau (103, 203, 301, 401) à k petit sous la forme d'une couche poreuse ;
• en introduisant le matériau d'introduction dans les pores de la couche en matériau (103, 203, 301, 401) à k petit.

## FIG 1   Stand der Technik

100

104                     105

$k=k_0$                 $k=k_0$

104      104

105

103

101                     102

## FIG 2

200

204                     205

203                     $k>k_0$

$k=k_0$                 206

201                     202

## FIG 3A

300

301

$k = k_0$

302

## FIG 3B

313

310

311

$k = k_0$ | $k > k_0$ | $k = k_0$

311

302

312

## FIG 3C

320

322

311

321

$k = k_0$ | $k > k_0$ | $k = k_0$

311

302

312

# FIG 4A

# FIG 4B

# FIG 4C

# FIG 4D

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20030107465 A1
- DE 2823881 A1
- US 20030232495 A1
- US 2002016085 A1
- US 6459562 B1
- WO 03015150 A
- EP 1195801 A
- US 20030201465 A1

**In der Beschreibung aufgeführte Nicht-Patentliteratur**

- **Mourier, T ; Jousseaume, V ; Fusalba, F ; Lecornec, C ; Maury, P ; Passemard, G ; Haumesser, PH ; Maitrejean, S ; Cordeau, M ; Pantel, R.** Porous low k pore sealing process study for 65 nm and below technologies. *IITC2003,* 2003
- **P.-T. Liu et al.** Effects of NH3-Plasma nitridation on the electrical characterisations of low-k hydrogene silsesquioxane with copper interconnects. *IEEE transactions on electron devices,* September 2000, vol. 47 (9), 1733-1739
- **C.-F. Yeh et al.** O2-plasma degradation of low-k organic dielectric and its effective solution for damascene trenches. *5th International Symposium on plasma process-induces damage,* Mai 2000, 81-8423-24
- The effects of plasma treatment for low dielectric constant hydrogen silsesquioxane (HSQ). **LIU P. T. et al.** THIN SOLID FILMS. ELSEVIER-SEQUOIA S.A, 02. November 1998, vol. 332, 345-350